(19) Europäisches Patentamt
European Patent Office
Office européen des brevets

(11) **EP 2 757 386 A1**

## (12) EUROPEAN PATENT APPLICATION

(43) Date of publication:
**23.07.2014 Bulletin 2014/30**

(51) Int Cl.:
***G01R 33/50*** *(2006.01)*    ***G01R 33/56*** *(2006.01)*

(21) Application number: **13000239.7**

(22) Date of filing: **17.01.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Ruprecht-Karls-Universität Heidelberg 69117 Heidelberg (DE)**

(72) Inventors:
• **Heiland, Sabine**
  **69121 Heidelberg (DE)**
• **Milford, David**
  **69221 Dossenheim (DE)**

(74) Representative: **Müller-Boré & Partner Patentanwälte PartG mbB Friedenheimer Brücke 21 80639 München (DE)**

(54)    **Synthetic parameter-weigthed images based on relaxometry (SPARE)**

(57)    The present invention relates to a magnetic resonance (MR) imaging technique which provides high contrast images at low data acquisition times that is not limited to but especially advantageously applicable at high magnetic fields, thereby providing particularly high spatial resolution. The invention is implemented as a magnetic resonance imaging method as well as a respective device and a computer program product. The Magnetic resonance imaging method comprises

- providing a $T_2$-map, which specifies for a plurality of voxels in a two-dimensional section of a target to be investigated a value $T_2$ of the magnetic resonance transverse relaxation time;

- deducing for each voxel a simulation time parameter value $T_1^*$ from the respective value $T_2$;

- providing a functional relationship $S = S(T_1)$ between a magnetic resonance signal $S$ that is expected to be measured for a predefined magnetic resonance pulse sequence and a value $T_1$ of the magnetic resonance longitudinal relaxation time at each voxel;

- calculating an imaging signal $S^* = S(T_1^*)$; and

- outputting a two-dimensional image of the imaging signal $S^* = S(T_1^*)$.

Fig. 11

EP 2 757 386 A1

**Description**

The present invention relates to a magnetic resonance (MR) imaging technique which provides high contrast images at low data acquisition times that is not limited to but especially advantageously applicable at high magnetic fields, thereby providing particularly high spatial resolution. Due to the short data acquisition times the described invention is advantageously applicable for direct in-time-imaging while performing the magnetic resonance measurement as well as for offline analysis.

With recent developments in magnetic resonance (MR) technology, magnetic resonance imaging (MRI) especially at ultra-high magnetic field strength has become of increasing interest and is currently performed up to about 9.4 T for human and up to about 17 T or even more than 21 T for animal studies. The increase in the magnetic field strength allows for an enhanced signal to noise ratio (SNR) and therefore an increase in the spatial resolution that can be obtained. One main concern, during the development of higher magnetic field strength, was the possible convergence of the molecular relaxation times, $T_1$ and $T_2$ . Such convergence would lead to a reduction in $T_1/T_2$ contrast.

It has been shown, however, that although the magnetic field strength increases, $T_1$, relaxation times tend to increase with the field strength, while $T_2$ remains somewhat unchanged showing no significant dependency on the magnetic resonance frequency. It has also been noted that there is a reduction of the tissue contrast in $T_1$-weighted images.

Therefore, it is a problem to provide improved magnetic resonance imaging with high contrast and high spatial resolution without a substantial increase in the required measurement time. This problem is solved by a method, a system and computer program product having the features defined in the independent claims. Preferred embodiments are defined in the dependent claims.

Accordingly, in one aspect the present invention provides a magnetic resonance imaging method that comprises a step of providing a $T_2$-map, which specifies for a plurality of voxels in a two-dimensional section of a target to be investigated a value $T_2$ of the magnetic resonance transverse relaxation time. The target is an object or a subject (e.g. an animal or a human) that may include living tissue to be investigated. The $T_2$-map identifies a section (e.g. a planar 2D-cross section) through that target. In particular, a plurality of positions over that section are identified as voxels (volume elements) in the target. For each of the plurality of positions, the $T_2$ -map specifies a value of the $T_2$-time, i.e. the transverse relaxation time (also known as a spin-spin relaxation time) of the tissue at that position and at a specific constant magnetic field. $T_2$ -maps *per se* are well-understood in the field of magnetic resonance imaging. They are often presented graphically as gray-scale maps, where each pixel of the gray-scale map represents a voxel (position) in the measured target, and where the gray shade of the image in that pixel represents the value of the $T_2$-time at that position. Accordingly, in connection with the present description the $T_2$ -map is understood as a set of data that assigns a value of the $T_2$ -time (at a specific/known magnetic field) to each of the plurality of voxels in the two-dimensional section of the target.

In one example, providing the $T_2$-map may comprise retrieving the previously stored data of the $T_2$ -map. In this example, the actual values of the $T_2$ -times may have been previously stored for each of the plurality of voxels. In another example, providing the $T_2$-map may comprise extracting or calculating the $T_2$-map from previously stored data of measured magnetic resonance signals. For example, the intensity map of a spin echo signal previously measured for a plurality of different echo times may have been stored. From this measured and stored signal the $T_2$ -map may be extracted. In yet another example, providing the $T_2$ -map may comprise measuring the values $T_2$ or measuring magnetic resonance signals and extracting or calculating the $T_2$ -map from the measured magnetic resonance signals. In other words, in this example the described imaging method may be used for in-time evaluation and/or presentation of magnetic resonance images, i.e. during or immediately after (preferably as an integral part of) the actual measurement process. This allows to support a user of the invention to control the measurement process, especially if a plurality of sections of the target should be investigated subsequently. In this case, the user can make immediate decisions on which sections to investigate/measure or whether/how to change/improve measurement parameter, such as the static magnetic field and/or spin echo times. More details about preferred implementations of extracting or calculating the $T_2$ -map from measured magnetic resonance signals will be described further below.

In any case, since $T_2$ values (i.e. magnetic resonance transverse relaxation times) are generally considerably shorter than magnetic resonance longitudinal relaxation times (typically referred to as $T_1$-times and also known as spin-lattice relaxation times), data acquisition (in particular measuring the required magnetic resonance signals for obtaining the $T_2$ -map) can be achieved clearly faster than corresponding $T_1$-maps, especially at high magnetic fields.

The method further comprises a step of deducing for each voxel in said two-dimensional section a simulation time parameter value $T_1^*$ from the respective value $T_2$ at the respective voxel. In other words, the present invention introduces an internal parameter (herein called the simulation time parameter value $T_1^*$), which is a function

$T_1^* = T_1^*(T_2)$ of the value $T_2$, i.e. the method assigns to each voxel a value of the internal parameter $T_1^*$ based on the respective value $T_2$ identified for said voxel via the $T_2$-map. Thus, the present invention provides a $T_1^*$-map, which specifies for each of the plurality of voxels in the two-dimensional section of the target a value of the internal parameter $T_1^*$. Preferably, the function $T_2 \rightarrow T_1^*(T_2)$ is a continuous function, more preferably a monotonic function, even more preferably a monotonically increasing function, most preferably a strictly (monotonic) increasing function. In one particularly preferred embodiment $T_1^*$ is a linear function of $T_2$, i.e. $T_1^*(T_2) = c \cdot T_2$ with a (preferably constant) factor $c$. In one example, the predefined function $T_2 \rightarrow T_1^*(T_2)$ is stored in a digital (e.g. electronic and/or magnetic and/or optical) storage of a computer-system. In order to deduce the $T_1^*$ values from the $T_{2'}$ the function $T_2 \rightarrow T_1^*(T_2)$ is retrieved from the digital storage and the applied to the provided $T_2$ values.

Moreover, the method according to the present invention includes a step of providing a functional relationship $S = S(T_1)$ between a magnetic resonance signal $S$ and a value $T_1$ of the magnetic resonance longitudinal relaxation time. In particular, the relationship $S = S(T_1)$ is a predefined function $T_1 \rightarrow S(T_1)$ that may be stored in a digital (e.g. electronic and/or magnetic and/or optical) storage of a computer-system. In one example, this digital storage may be the same (e.g. the same hard drive) as the one for storing the predefined function $T_2 \rightarrow T_1^*(T_2)$. The functional relationship $S = S(T_1)$ assigns to a value $T_1$ of the magnetic resonance longitudinal relaxation time of a tissue the magnetic response signal $S$ that is expected to be measured for a particular (predefined) magnetic resonance pulse sequence. In this sense the predefined functional relationship may be understood as a simulation of the magnetic resonance signal $S$ for that specific magnetic resonance pulse sequence. The magnetic resonance pulse sequence represented by the functional relationship $S = S(T_1)$ may include at least one of a spin echo sequence (single-echo or multi-echo) (sometimes referred to as SE sequence) and an inversion recovery sequence (sometimes referred to as IR sequence) and a gradient echo sequence and a diffusion pulse sequence and a saturation recovery sequence, for example. Specifically preferred implementations are described in more detail further below.

Depending on the specific magnetic resonance pulse sequence, the functional relationship $S(T_1)$ may depend on one or more parameters, such as the static magnetic filed and/or a spin echo time $TE$ and/or a pulse repetition time $TE$ and/or an inversion (recovery) time $TI$. Moreover, depending on the specific magnetic resonance pulse sequence, the functional relationship $S(T_1)$ may depend on one or more additional variables, such as the transverse relaxation time $T_2$. In this case it may be represented by $S = S(T_1, T_2)$.

In one example, a plurality of different functional relationships may be stored, each representing a different magnetic resonance pulse sequence, where a user may select (e.g. via a user interface) one of the magnetic resonance pulse sequences, the corresponding functional relationship of which is thereby provided for the further use in the method of the present invention.

Based on the functional relationship $S(T_1)$ the method according to the present invention calculates an imaging signal $S^*$ by applying the functional relationship $S(T_1)$ to the internal parameter map $T_1^*$, where the $T_1^*$ values are treated as if they were longitudinal relaxation times $T_1$. Accordingly, in the functional relationship $S(T_1)$, the $T_1$ times are replaced by the simulation time parameter value $T_1^*$, so that an imaging signal $S^* = S(T_1^*)$ is calculated for each value $T_1^*$, i.e. for each voxel. If the functional relationship $S(T_1)$ also depends on the transverse relaxation time $T_2$, it is preferred that the values of the $T_2$-map used for calculating the imaging signal $S^* = S(T_1^*, T_2)$.

Finally, the method according to the invention comprises a step of outputting a two-dimensional image of the imaging signal $S^* = S(T_1^*)$. The inventors have found that thereby variations and transitions in tissue can be effectively and quickly investigated and identified due to a surprisingly strong contrast structure in the output image even at high magnetic field, and thus with a remarkably high spatial resolution and signal-to-noise ratio, but without requiring extensive measurement times as they should be expected when including real $T_1$ measurements.

Preferably, the $T_2$-map is provided for a magnetic field of at least about 1.5 T, more preferably at least about 5 T, even more preferably at least about 7.5 T most preferably at least about 9 T. Although the invention is not limited to high magnetic field, the proposed approached applied by the present invention allows to utilize the high signal-to-noise ratio that can be achieve at high magnetic fields without suffering from an extensive measurement duration that is often required for conventional MR imaging processes that rely on the measurement of $T_1$-weighted maps. In other words, the present invention is applicable to both low magnetic field and high magnetic field, where the present invention is most superior to many conventional methods especially in the high magnetic field regime.

As already mentioned, in one preferred embodiment, $T_1^*$ is a linear function of $T_2$. In a further preferred embodiment, the method comprises providing a PD-map, which specifies for each of the voxels in the two-dimensional section of a target to be investigated a value $p$ of the proton density. Based on this proton density, it is particularly preferred that $T_1^*$ is a linear function of the ratio $\dfrac{T_2}{\rho}$ for each voxel.

In one example, providing the PD-map may comprise retrieving previously stored data of the PD-map. In this example, the actual values $\rho$ of the proton density may have been previously stored for each of the plurality of voxels. In another example, providing the PD-map may comprise extracting or calculating the PD-map from previously stored data of measured magnetic resonance signals. For example, the intensity map of a spin echo signal previously measured for a plurality of different echo times may have been stored. From this measured and stored signal the PD-map may be extracted. In yet another example, providing the PD-map may comprise measuring the values PD or measuring magnetic resonance signals and extracting or calculating the PD-map from the measured magnetic resonance signals. In other words, in this example the described imaging method may be used for in-time evaluation and/or presentation of magnetic resonance images, i.e. during or immediately after (preferably as an integral part of) the actual measurement process. This allows to support a user of the invention to control the measurement process, especially if a plurality of sections of the target should be investigated subsequently. In this case, the user can make immediate decisions on which sections to investigate/measure or whether/how to change/improve measurement parameter, such as the static magnetic field and/or spin echo times. More details about preferred implementations of extracting or calculating the PD-map from measured magnetic resonance signals will be described further below.

Preferably, the method further comprises a step of determining a pulse repetition time TR and a spin echo time TE of a spin echo pulse sequence, wherein the functional relationship between the magnetic response signal and the longitudinal relaxation time is provided as $S(T_1) = b\left(1 - \exp\left(-\dfrac{TR}{T_1}\right)\right)\exp\left(-\dfrac{TE}{T_2}\right)$ with a predefined factor $b$.

Preferably, $b$ does neither explicitly depend on $T_1$ nor on $T_2$. Determining TR and/or TE may be achieved by receiving from a model repository a respective predetermined value. In another embodiment, TR and/or TE may be retrieved from a user input. In yet another embodiment, it is particularly preferred that TR and/or TE are automatically determined depending on the values of $T_1^*$ and/or $T_2$, respectively. It will be appreciated that with the selection of TR and/or TE the image contrast can be influenced, particularly optimized.

In another preferred embodiment, the method further comprises determining an inversion time TI, a pulse repetition time TR, and a spin echo time TE of an inversion recovery pulse sequence, wherein the functional relationship between the magnetic response signal and the longitudinal relaxation time is provided as

$$S(T_1) = b\left(1 - 2\exp\left(-\dfrac{TI}{T_1}\right) + \exp\left(-\dfrac{TR}{T_1}\right)\right)\exp\left(-\dfrac{TE}{T_2}\right)$$ with a predefined factor $b$.

Preferably, $b$ does neither explicitly depend on $T_1$ nor on $T_2$. Determining TI and/or TR and/or TE may be achieved by receiving from a model repository a respective predetermined value. In another embodiment, TI and/or TR and/or TE may be retrieved from a user input. In yet another embodiment, it is particularly preferred that TI and/or TR and/or TE are automatically determined depending on the values of $T_1^*$ and/or $T_2$, respectively. It will be appreciated that with the selection of TI and/or TR and/or TE the image contrast can be influenced, particularly optimized.

In a further preferred embodiment, the method comprises a step of providing a PD-map, which specifies for each of the voxels in a two-dimensional section of a target to be investigated a value $\rho$ of the proton density of the tissue in the respective voxel. In a specifically preferred embodiment, the factor $b$ in one of the above mentioned embodiments is proportional to the proton density $\rho$. Providing the $PD$-map may be implemented as explained further above, for example.

In a preferred embodiment, especially when using a functional relationship between the magnetic response signal and the longitudinal relaxation time in accordance with a spin echo sequence and/or an inversion recovery sequence, the method comprises receiving a user input that specifies the pulse repetition time $TR$ parameter to be used in the corresponding functional relationship when calculating the imaging signal. Alternatively or additionally, the method preferably comprises receiving a user input that specifies the spin echo time $TE$ parameter to be used in the functional relationship when calculating the imaging signal. In a preferred embodiment, the user may input and/or modify the pulse repetition time $TR$ parameter and/or the spin echo time $TE$ parameter via a virtual slider of a graphical user interface, while the calculation of the imaging signal and its graphical presentation is immediately updated so that the user can directly experience the influence of amending the parameters $TR$ and/or $TE$ on the resulting tissue contrast. Various (alternative) user interfaces, such as adjusting knobs and/or arrows can be applied for allowing the user to increase and/or decrease the respective parameter. Thereby the user can very quickly and efficiently optimize the tissue contrast in a manner that is flexibly adapted to the individual requirements.

As already mentioned above, in a preferred embodiment, the $T_2$-map may be extracted or calculated based on measured MR signals. In particular, providing the $T_2$-map preferably comprises:

- acquiring for each voxel a plurality of spin echo signals $S$ of a spin echo pulse sequence at different spin echo times $TE$ (and preferably at constant pulse repetition time $TR$); and
- identifying for each voxel a respective value for parameters $a$, $S_0$, and $T_2$ such that the curve

$$S(TE) = a + S_0 \exp\left(-\frac{TE}{T_2}\right)$$ fits the acquired value pairs ($TE,S$) best (e.g. with least mean square deviation).

The fitting is carried out for each voxel separately.

In different preferred embodiments other fitting processes may be implemented in order to acquire the relaxation times $T_2$ for the plurality of voxels based in the measured MR signals. For example another non-linear fitting, analogous to the one describe above, but with no baseline parameter $a$ may be applied by fitting the curve

$$S(TE) = S_0 \exp\left(-\frac{TE}{T_2}\right)$$ to the measured values. In yet another preferred embodiment the relaxation times $T_2$ may

be acquired by linear fitting of the curve $\ln(S(TE)) = \ln(S_0) - \frac{TE}{T_2}$ (e.g. based on a least mean square deviation).

In yet another preferred embodiment, an algebraic calculation is made based on an eight-echo acquisition, i.e. based on measured MR signals $S_1$, $S_2$,... $S_8$ for eight subsequent spin echo, where $TE$ represents the first echo time as well as the time between the echos. In this example the relaxation times $T_2$ for each voxel may be acquired via:

$$T_2 = 2 \cdot \frac{TE}{\ln(S_1 + S_2 - S_5 - S_6) - \ln(S_3 + S_4 - S_7 - S_8)}$$

In yet another example a double spin echo sequence may be acquired with equal spacing $TE$ between the first echo and the second echo, where the measure signals for the first and second echo are $S_1$ and $S_2$, respectively. In this example the relaxation times $T_2$ for each voxel may be acquired via:

$$T_2 = \frac{TE}{\ln(S_1) - \ln(S_2)}.$$

This is especially applicable if the first and second echoes are used and the spacing is the same. The more preferred means of this technique is to use two echo times widely separated: one where $TE$ is low and $T_2$ effects are minimal and one where $TE$ is high moving towards but not into the noise region. In this case the relaxation times $T_2$ for each voxel may be acquired via:

$$T_2 = \frac{TE_2 - TE_1}{\ln(S_1) - \ln(S_2)}$$

In another aspect, the present invention provides a magnetic resonance imaging device, comprising:

- a data acquisition module for providing a $T_2$-map, which specifies for a plurality of voxels in a two-dimensional section of a target to be investigated a value $T_2$ of the magnetic resonance transverse relaxation time;

- a time simulation module for deducing for each voxel a simulation time parameter value $T_1^*$ from the respective value $T_2$;

- a model repository for providing a functional relationship $S = S(T_1)$ between a magnetic resonance signal $S$ that is expected to be measured for a predefined magnetic resonance pulse sequence and a value $T_1$ of the magnetic resonance longitudinal relaxation time at each voxel;

- a signal simulation module for calculating an imaging signal $S^* = S(T_1^*)$; and

- an imaging module for outputting a two-dimensional image of the imaging signal $S^* = S(T_1^*)$.

Preferably the device is adapted to perform a method according to the present invention, in particular according to one of the preferred embodiments as described herein.

Preferably, the data acquisition module comprises a magnetic resonance imaging scanner, particularly including a magnet and a radio frequency generator as well as a magnetic resonance detector.

Preferably, the functional relationship between the magnetic response signal and the longitudinal relaxation time is provided as $S(T_1) = b\left(1 - \exp\left(-\frac{TR}{T_1}\right)\right)\exp\left(-\frac{TE}{T_2}\right)$ with a predefined factor $b$, a pulse repetition time $TR$, and a spin echo time $TE$, wherein the device further comprises a user interface for receiving a user input that specifies the pulse repetition time $TR$. The user interface may be provided in the form of a slider via which the user may continuously change the parameter $TR$ while watching/observing the influence of this change on the visualization of the imaging signal $S^*$. This allows a very quick and efficient optimization of image contrast flexibly adapted to the individual requirements.

The invention can be implemented in digital electronic circuitry, or in computer hardware, firmware, software, or in combinations of them. The invention can be implemented as a computer program product, i.e., a computer program tangibly embodied in an information carrier, e.g., in a machine-readable storage device or in a propagated signal, for execution by, or to control the operation of, data processing apparatus, e.g., a programmable processor, a computer, or multiple computers. A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or on multiple computers at one site or distributed across multiple sites and interconnected by a communication network.

Method steps of the invention can be performed by one or more programmable processors executing a computer program to perform functions of the invention by operating on input data and generating output. Method steps can also be performed by, and apparatus of the invention can be implemented as, special purpose logic circuitry.

These and other objects, features and advantages of the present invention will become more apparent upon reading of the following detailed description of preferred embodiments and accompanying drawings. It should be understood that even though embodiments are separately described, single features thereof may be combined to additional embodiments.

Fig. 1: illustrates a typical $T_1$ curve with varying $TR$ that is used to determine the $T_1$ times;

Fig. 2: illustrates a typical $T_2$ decaying curve used for the determination of $T_2$ times;

Fig. 3: shows $T_1$-weighted measurements, i.e. with different *TR* and constant *TE*. These measurements are used for calculating $T_1$ times, e.g. by fitting;

Fig. 4: shows $T_2$-weighted measurements, i.e. with different *TE* and constant *TR*. These measurements are used for calculating $T_2$ times and preferably also for calculating proton densities, e.g. by fitting;

Fig. 5: shows resulting Q-maps ($T_2$: left, $T_1$: middle, and *PD*: right) of a healthy control mouse. Magnified squares present the resolution of the maps and illustrate the contrast by with the ability to visualize major arteries coming from the border of the Putamen;

Fig. 6: shows an illustration of a single mouse with a glioma tumor and the resulting Q-maps for a single slice $T_1$ and $T_2$ mapping. Images presented for Pre-CA (top line) and Post-CA (bottom line). Decrease signal relating to a reduction in the relaxation times is noted Post-CA images for both the $T_1$ and $T_2$ Q-maps within the tumor mass;

Fig. 7: shows a comparison of standard $T_2$- (A) and $T_1$- (B) weighted images and synthesized images based on the same imaging parameters for $T_2$ (C, TR set at 2500ms and TE at 42ms) and $T_1$ (D, TR set at 900ms and TE at 8.7ms). It is noted that the synthesized images depict a reduction in pixelation, yielding smoother images than the standard acquired weighted images. Furthermore, the edema formed boundary of the tumor is more defined in C than in its standard counterpart;

Fig. 8: shows a comparison of originally acquired mappings (top row) and synthesized images Pre-CA (middle row) and Post-CA (bottom row) with the same *TR* and *TE* parameters. A clear increase in the signal to noise ratio is noted in the synthesized images. Moreover, a further enhancement of the tumor and contrast agent is seen in the reconstructed images when comparing them to the originally acquired mappings with the same *TR* and *TE* parameter settings;

Fig. 9: shows an illustration of synthesized images based on the $T_2$ and $PD_2$ Q-maps before (top row) and after (middle row) CA using a *TE* of 1 (left) and 28 ms (right) with a *TR* of 3800ms. The post CA images, illustrates the value of this technique. By varying the *TE*, one is able to weight the images for the desired contrast without having a multi-slice $T_1$ map. The bottom group of images presents the tumor post-CA over multiple slices;

Fig. 10: shows an illustration of the $T_1^*$ map (right) and standard $T_1$ map (left). A noticeable reduction of signal intensity in fatty tissue around the brain can be noted. Improved "mapping" around regions with large difference in $T_1$ time such as CSF and bone yielding smoother boundaries;

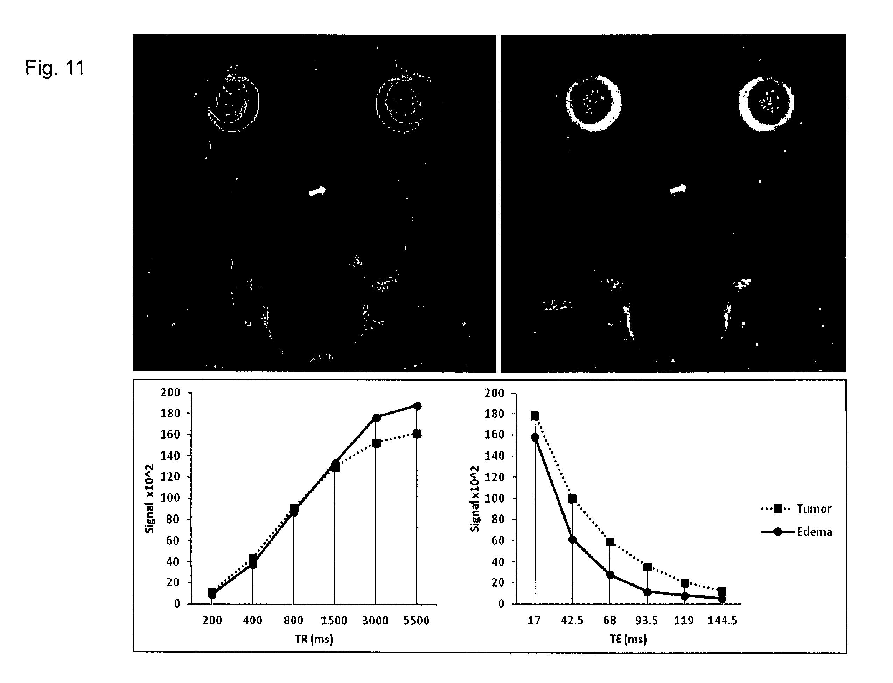

Fig. 11: shows standard $T_1$ map (Left) compared to a $T_1^*$ map (Right) with a contrast enhanced tumor. Edema in the standard $T_1$ map has gone hyperintense as shown by the white are and matches closely to the intensity of the tumor (black arrow). This is not the case in the $T_1^*$ maps where the two entities are clearly visible separately. The two plotted curves illustrate the signal curves for $T_1$ fitting (Left) and $T_2$ fitting (Right). From this it is evident that regions of edema will produce similar relaxation times as contrast enhanced tumors in $T_1$ mappings. When $T_2$ mapping is undertaken the curves are clearly discernible and thus so are the edema from the CA enhanced tumor;

Fig. 12: shows $T_2$-weighted (A, B: *TR*= 3000, *TE*=40) and $T_1$-weighted (C, D: *TR*= 900, *TE*=8) synthesized images with a standard $T_1$ map (A, C) and a $T_1^*$ map (B, D); and

Fig. 13: shows synthesized weighted images with a standard $T_1$ map (left column) and a $T_1^*$ map (right column). For both the $T_2$-weighted images (A, B) the tumor region (hypointense) is well defined with an edema (hyperintense) boarder. The $T_1$-weighted images (C, D), however, show a difference with respect to the size of the hyperintense tumor due to the "incorrect" mapping explained further below. As a further proof of the use of this technique, synthesized *IR* images (E, F) are shown, illustrating the ability to suppress "signal" outside the tumor boarder.

One major advantage achieved by the present invention is to synthesize parametric weighted images is of multi-slice $T_1$ Q-maps. This is of significant importance due to the number of and extremely long TR times that are conventionally needed for directly measuring the mappings which yields a therefore long scanning time. This long scanning time is therefore an issue for clinical routines.

The present invention, however, provides a very efficient way to synthesize $T_1$-weigthed images based on relaxometry. In particular, it will be explained in more detail, how the present invention achieves the synthesis of images based on Q-maps (particularly $T_2$-maps and/or $PD$-maps) with a desired contrast offline. Comparisons between standard $T_1$ and $T_2$ weighted images and synthesized images will be made showing the potential of this technique. Furthermore, it will be illustrated how one can still synthesis images with enhanced contrast and enhancing the effect of a contrast agent without the need of deducing $T_1$ -maps from actual $T_1$ -weighted measurements. This particularly shows the potential of multi-slice contrast enhanced synthetic images based purely on acquired $T_2$ -mappings (and possibly on $PD$-mappings, if desired). As a vital parameter in MRI is the repetition time, which allows for $T_1$ weighting, this work will present a means of simulating a $T_1$ Q-map for contrast agent enhancement. Using these simulated maps along with the other obtained Q-maps, it will be presented that with one acquired mapping at the MRI an investigator can preferably obtain the contrast of a minimum of 4 different weighted images.

Relaxometry has become the conventional term used for the measurements of quantitative relaxation times. Before imaging became an application of MR, relaxometry was seen as the study of the process and means that gave rise to the relaxation event. Three predominant quantitative measurements are commonly inspected with relaxometry. These quantitative values include the proton or spin density ($PD$) and the two relaxation times $T_1$ and $T_2$. $PD$ specifies the concentration of protons that provide the MR signal of a tissue. $T_1$ represents the longitudinal relaxation that provides the time a molecule relaxes back to line up with the static magnetic field and $T_2$ represents the transverse relaxation that provides information as to the dephasing of the spin precession. The $T_1$ relaxation is conventionally ascribed mainly to spin-lattice interaction, while the $T_2$ relaxation is conventionally ascribed mainly to spin-spin interaction. In the following it will be discussed in more detail, what these quantities are and how they can be attained. As this topic is a large and important topic in MRI, not all aspects of this technique will not be described here, but it is referred to the conventional textbook knowledge for further details.

As has already been stated, Proton Density ($PD$) refers to the concentration of protons (in most cases the hydrogen nuclei) within a tissue. It is the basis of all MR images and thus the image intensity is proportional to $PD$. Absolute proton concentration is dependent of the number of protons within a unit volume. Thus, knowing the number of protons, $NP$, the density within a tissue, $\rho$, and the molecular mass, $MWt$, one can determine the absolute proton concentration ($PC$) in Mols, of a certain chemical compound by:

$$PC = \frac{NP \cdot \rho}{MWt}$$

Measuring proton density can be achieved by using a spin-echo sequence (SE) and the signal equation:

$$S = k \cdot PD \left(1 - \exp\left(-\frac{TR}{T_1}\right)\right) \exp\left(-\frac{TE}{T_2}\right) \qquad (1)$$

In the SE sequence, a 90° radio frequency pulse flips the spins from their longitudinal alignment (along the magnetic field) to a transverse direction and the spins start a precession movement with the Lamor frequency. This precession movement can be detects due to its emission of radio frequency signals. Due to relaxation effects, the spin precession dephases and the spins return to their longitudinal alignment. Therefore, the detected radio frequency signal decreases. In order to compensate dephasing of the spins due to inhomogeneities of the longitudinal magnetic field, a 180° radio frequency pulse is applied after a certain time (namely $TE$/2) and a spin echo is observed at a time $TE$ after to 90° excitation pulse. At a time $TR$ after the first 90° pulse, the sequence is repeated starting with the next 90° pulse. Equation (1) describes the observed signal, where $k$ is thought of as the signal gain of the receiver and is the signal that is coming from the different tissues and which is not ascribed to losses due to $T_1$ or $T_2$. Although it is possible to measure this gain, it would require a full saturation of $T_1$ relaxation ($TR \to \infty$) and fitting the $T_2$ curve to obtain a signal where $TE = 0$ .

Preferably, in order to calculate PD first one calculates the $T_1$ and $T_2$ times. This may be achieved as described below. Once the respective relaxation times have been found, they can be substituted back in to the above SE equation (1). Although it is common to use signals where $TE$ is much less than $T_2$, to exclude $T_2$ effects, and $TR$ is much greater than $T_1$, to exclude $T_1$ effects, the $PD$ can still be influenced by short $T_2$ times, temperature, and improper 90° and/or 180° excitation pulses.

As far as SE sequences are exemplarily used throughout the following description of preferred embodiments, it is desired to understand the role the sequence has on obtaining the "true" proton density. The proton density is related to the $T_2$ relaxation times. With longer times, within SE sequences, protons are visible but may have a reduced signal. If, however, the $T_2$ relaxation time of the compound is extremely short, they become invisible during an image acquisition but can be detected using spectroscopy. Therefore, the number of visible protons is dependent of the echo time. The advantage of using $PD$-weighted sequences ($TR \gg T_1$ and $TE \ll T_2$) is the sensitivity to high water contents such as that seen in inflammation and edema in the brain.

$T_1$ relaxation mapping refers to the determination of the time a molecule "relaxes" back in line with the main magnetic field direction. This relaxation happens from the excited transverse plane to the longitudinal direction. $T_1$ times do not only provide information regarding the biological tissue but also the uptake of different agents. For example a positive contrast agent such as Gadofluorine M (Bayer Schering Pharma AG, Germany) shortens the $T_1$ time allowing for pathological regions to be hyperintense with in sequences that are $T_1$-weighted. The measurement of $T_1$ can be done in many ways. It is commonly accepted that for optimal mapping of $T_1$ an infinitely long $TR$ with an infinite number of different $TR$s would allow complete relaxation of the molecule. This being said, however, is not possible and not practical for clinical routines. Different techniques for mapping $T_1$ have been developed. One commonly used is an inversion recovery (IR) sequence or a standard SE sequence.

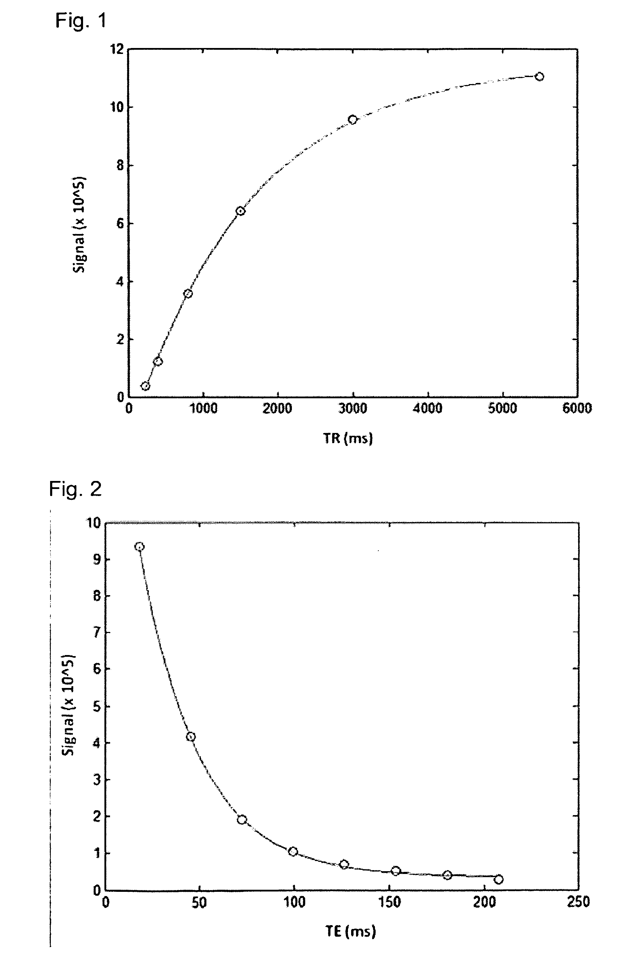

When mapping with a typical SE sequence a low $TE$ is selected and fixed to reduce the influence of $T_2$ within the image and $TR$ is varied, e.g. from low to high $TR$ times. It is common practice to have short time differences between $TR$ at the beginning of the mapping and increasing the time difference at the end. The reason for this is due to the saturation/full relaxation of the molecule at longer $TR$. Fig. 1 illustrates a typical $T_1$ curve with varing $TR$ that is used to determine the $T_1$ time. The time of $T_1$ can then be calculated by curve fitting and the use of equation (1) above. That is by fitting the signal relating to each $TR$ time in the equation

$$S = a + k \cdot PD \left( 1 - \exp\left( -\frac{TR}{T_1} \right) \right) \qquad (2)$$

where $a$ is an offset parameter that is preferably used in the fitting process. Thereby, $T_1$ can be deduced.

Another typical approach to determining $T_1$ is using an inversion recovery technique. In a IR sequence a 180° pulse (inversion pulse) is applied prior to the 90° excitation pulse. The time between the inversion and excitation pulse is known as the inversion time $(TI)$. At a certain $TI$ the $T_1$ time can be cancelled out allowing for the determination of $T_1$. The so called $TI_{null}$ time refers to the $TI$ time where $T_1$ is nullified. This is simply calculated by $TI_{null} = \ln(2) \cdot T_1$. For an IR based mapping the $TR$ may be set at five times $T_1$ to allow for sufficient relaxation between measurements. Again fitting a curve of the signal and the $TI$ time can result in the determination of $T_1$ by using the following equation:

$$S = k \cdot PD \left( 1 - 2 \cdot \exp\left( -\frac{TI}{T_1} \right) \right) \qquad (3)$$

As a side point it is due to the ability to nullify/suppress a specific $T_1$ that IR based sequences are preferably used when imaging areas with high blood, water or fat. It allows on to decrease the visual signal for these biological entities which in turn increases the contrast of other bounded pathologies.

As $T_2$ relaxation is "easier" to measure when compared to $T_1$, there is a vast resource of literature explaining the fundamental principles behind this process. In brief, $T_2$ relaxation is the time of exchange of the nuclei with the neighboring nuclei and can be termed spin-spin relaxation. Like $T_1$ relaxation, the decay is also exponential (decay) and is the time taken for 63% of the transverse magnetization to decay. That is transverse relaxation is the distribution of the energy within the spin system. It should also be noted that the word relaxation is misleading as it is a decaying process or in other words it is the rate at which the signal decreases. During the transverse relaxation the bulk magnetization (M) decays resulting in the net component of M within the transverse plane to dephase and can be seen as individual isochromats losing phase coherence. Therefore, the $T_2$ time is the time of dephasing after excitation. Setting $TE$ at a desired time allows an image to be more or less $T_2$ weighted. That is, at short $TE$ read out of the signal is taken before or just after dephasing starts to occur with longer $TE$ the investigator waits for dephasing of a desired time and then records the signal. Thus, a $T_2$ weighted image of a desired biological region of known $T_2$ can be achieved by setting the *TE* time accordingly (preferably just under or close to the $T_2$ time). Mapping of the $T_2$ time can be undertaken by fixing a high *TR* time (to exclude $T_1$ influences) and varying *TE*. The end *TE* time should also be reasonably high to allow for a signal saturation or nullification. Once the signal of different *TE* s has been acquired a curve of the signal against the *TE* time can be plotted and the $T_2$ time can be calculated by fitting it with the equation

$$S = a + k \cdot PD\left(\exp\left(-\frac{TE}{T_2}\right)\right) \qquad (4)$$

where a is again an offset parameter for more accurate fittings. Fig. 2 illustrates a typical $T_2$ decaying curve used for the determination of $T_2$.

Standard sequences used for mapping $T_2$ can include a standard SE sequence, Multiple-Spin-Echo sequence (MSE) and a Carr-Purcell Meiboom Gill (CPMG) sequence. Multi-Slice-Multi-Echo sequences (MSME) allows for a fast means of acquiring images of different echo times needed for mapping. It is based on one 90° excitation pulse and with a 180° refocusing pulse for each *TE* time within one repetition time or phase encoding step. Although this technique allows for multiple slice images at different *TE* , the diminished signal at longer *TE* times is not only due to the dephasing but also due to thermal effects as the molecules are not given time to relax and a new excitation pulse is not provided. This issue worsens with the number of sampled *TE* times as the energy provided by the initial 90° excitation pulse dies out.

As mentioned above, a typical SE sequence relies on an excitation pulse at 90° followed by a refocusing pulse of 180°. One can decrease the time of acquisition by repeating only the 180° refocusing pulse for a number of phase encoding lines. The number of repeating 180° pulse is known as the echo train. This method can be used to calculate the $T_2$ time. The problem, however, is that this method was susceptible to incorrect 180° pulses and diffusion effects. The Carr-Purcell-Meiboom-Gill sequence (CPMG) provides a means of measuring the $T_2$ with a echo train of 180° refocusing pulse while taking into account the imperfect 180° pulsations and diffusion effects. The basic idea behind this technique is to refocus using (180°-*e*) where *e* refers to the angle of imperfection of the true 180° pulse. However, as the number of echo train increases, the signal will still die out as a 90° excitation pulse is no longer in play. Using a standard SE sequence will provided accurate $T_2$ measurements as it provides a new 90° excitation and 180° refocusing pulse for every phase encoding line and, therefore, the *TE* in the phase encoding direction will have little to no variations. For this reason it may be advantageous in one aspect of the invention to rapidly acquire data with a relaxation enhancement (RARE) sequence. Much like the Carr-Parcell approach, this sequence uses an echo train (series of repeating 180°) to accelerate imaging. However, the number of echo trains may be kept low (around 2) to reduce/neglect the diffusion and incorrect pulse angle effects.

The following summary explains preferred ranges of the parameters TE and *TR* for achieving differently weighted maps and/or quantitative maps (Q-maps):

In order to provided $T_1$-weighted maps it is preferred to use short *TR*-times (e.g. about 250-700 ms) and short *TE* -times (e.g. about 10-25 ms). This may result in an exaggeration of the effects of $T_1$ and a diminution of the effects of $T_2$ in the image contrast. Under these conditions fats typically appear hyper-intense, while water typically appears hypo-intense.

In order to provide $T_2$-weighted maps it is preferred to use long *TR*-times (e.g. about 2000 ms or more) and long *TE*-times (e.g. about 60 ms or more). This may result in a diminution of the effects of $T_1$ and an exaggeration of the effects of $T_2$ in the image contrast. Under these conditions water typically appears hyper-intense, while fats typically appear hypo-intense.

In order to provide proton density maps it is preferred to use long *TR*-times (e.g. about 2000 ms or more) and short *TE*-times (e.g. about 10-25 ms). This may result in a diminution of the effects of $T_1$ and $T_2$ in the image contrast. Under these conditions tissues with high proton density typically appear hyper-intense, while tissues with low proton density typically appear hypo-intense.

Before explaining further aspects of the invention in more details, experimental parameters are described as they are used for demonstrating the effect of the invention in comparison to conventional imaging processes. Thus, in the following, the application of synthetic parameter-weighted imaging will be explained as it may be implemented in a preferred embodiment of the present invention. It will be divided into results of quantitative mappings and the synthesized reconstructed images based on the quantitative maps. Furthermore, although results of the invention will be shown mainly at a magnetic field of about 9.4T it has been turned out the invention is also applicable to lower and higher magnetic fields with comparable advantages.

In order to illustrate that synthesized images can be used as a replacement for standard weighted images, multiple sequence were run as controls for this technique as well as relaxometry mapping sequences before and after the injection of a contrast agent (CA). All scans were performed on a 9.4T horizontal bore MNR scanner (BioSpec 94/20 USR, Bruker BioSpin GmbH, Ettlingen, Germany) with a four channel phased array surface coil. Furthermore, to ensure stability in the mappings and to provide for more stable controls all sequences were based on a Rapid Acquisition with Refocused Echoes (RARE) sequence. This sequence is based on a standard SE sequence but allows for a rapid filling of the k-space by repeating the 180° refocusing pulse a number of time (controlled by a so called RARE factor at Bruker machines) before applying the next 90° excitation pulse. The number of repeating 180° pulses is known as the echo train. It should be noted though that the larger the echo train, the larger the signal reduction and, therefore, it should be used with care for relaxometry mappings as it should be the reduction due to the extension of the $TE$ that causes signal reduction giving a more reliable $T_2$ fit.

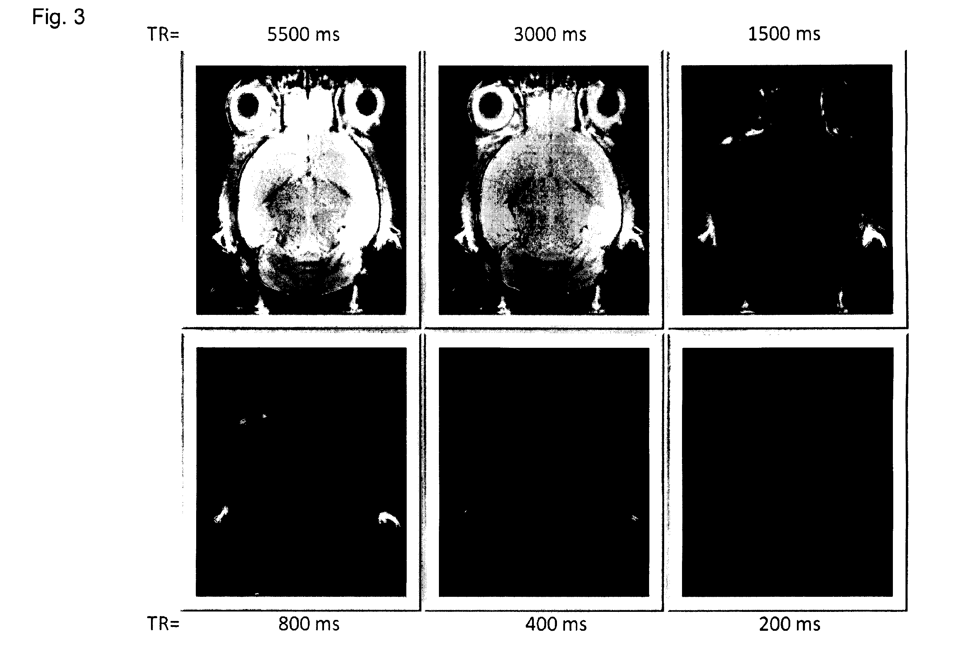

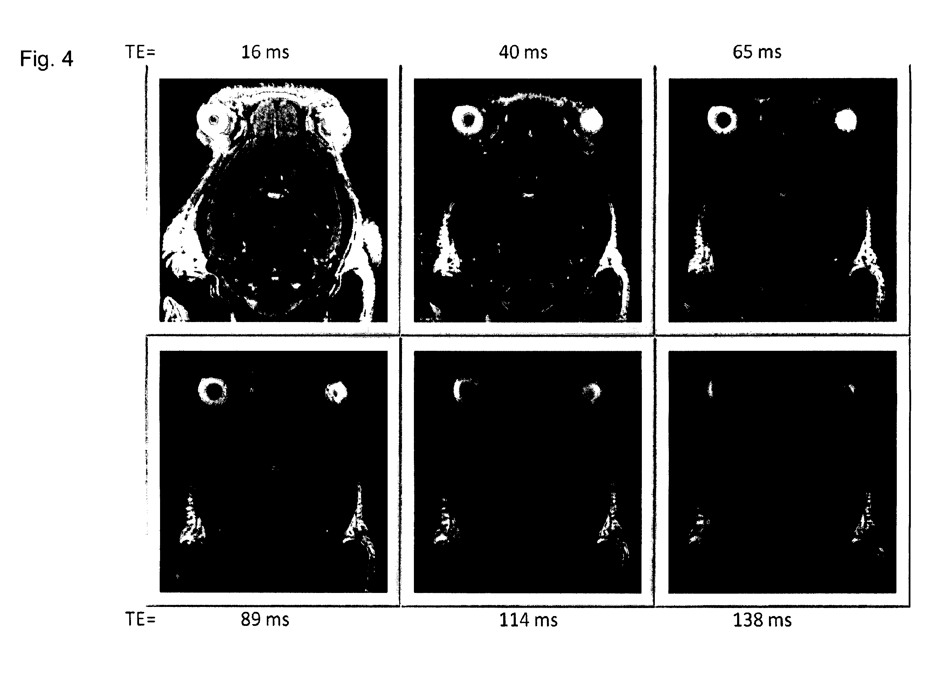

The MRI protocol was undertake as follows: Firstly a $T_2$ -weighted ($TR$ / $TE$ : 2500/42ms, NA: 3, echo train length: 5, matrix: 256 x 256, pixel spacing: 0.078 x 0.78mm, slice thickness: 0.3mm with a inter-slice spacing of 0.3mm, number of slices: 25, total time of 6min 23sec) images was acquired followed by a single slice $T_1$ and $T_2$ mapping ($TR$: [5500, 3000, 1500, 800, 400, 200]ms, $TE$ : [17, 42.5, 68, 93.5, 119, 144.5]ms, NA: 1, echo train length: 3, matrix: 256 x 256, pixel spacing: 0.078 x 0.78mm, slice thickness: 1mm with a inter-slice spacing of 1mm, total time of 12min 10sec) and a multi-slice mapping where the $TR$ is fixed and the $TE$ is varied allowing for a multi-slice $T_2$-mapping ($TR/TE$: 3809/[16, 40, 65, 89, 114, 138]ms, NA:2, echo train length: 3, matrix: 256 x 256, pixel spacing: 0.078 x 0.78mm, slice thickness: 0.3mm with a inter-slice spacing of 0.3mm, number of slices: 25, total time of 8min 8sec). Following the acquisition of the above mentioned sequences, the animals with implanted tumor cells, were injected, i.p. with 100µL of Omniscan (0,5mmol/ml, GE Healthcare Buchler GmbH, Germany) CA within the scanner to limit the amount of movement for pre and post comparison. In order to ensure complete uptake of the CA within the tumor, a waiting time of 5min was undertaken before continuing with the protocol. Following the waiting period, a standard $T_1$-weighted sequence ($TR/TE$: 905/8.5ms, NA: 3, echo train length: 2, matrix: 256 x 256, pixel spacing: 0.078 x 0.78mm, slice thickness: 0.3mm with a inter-slice spacing of 0.3mm, number of slices: 25, total time of 5min 48sec) was run followed by both the single slice $T_1$ and $T_2$ mapping and the multi-slice $T_2$-mapping acquired again. It will be appreciated that the above mentioned values for $TE$ and $TR$ are only examples. Other values have also been tested successfully. Figs. 3 and 4 illustrate typical images of MR signals for varying $TR$ values (Fig. 3) or varying $TE$ values (Fig. 4). These MR signals may be taken as basis for deducing quantitative maps, i.e. the maps of $T_1$ times and/or $T_2$ times and/or proton density (PD).

In particular, $T_2$ maps may be determined with a fixed $TR$ ($TR$ = 3000ms for the single slice mapping and 3800ms for the multi-slice relaxometry mapping) and all variation (from lowest to longest time) of $TE$ . On the other hand, $T_1$ maps may be determined by using the various acquired $TR$ images with the lowest $TE$ time ($TE$ = 17ms). For the $PD$ maps of the single slice mapping, the $T_1$ and $T_2$ maps, calculated prior to this process, may be substituted back into equation (1). For this mapping, acquired images of a typical $PD$ weighting (long $TR$ and short $TE$ to exclude $T_1$ and $T_2$ effects respectively) may be used for the calculation. That is images with a $TR$ of 55000ms, a $TE$ of 17ms may be used as the signal values needed for equation (1). Due to the non-trivial determination of true PD, the proportionality constant $k$ may be included in the final results of the $PD$ map. This incorporated proportionality constant will not be of detriment to the image synthesis as it will only enhance the final calculated signal of the synthesized images.

As the multi-slice $T_2$ mapping offers no knowledge of the actual $T_1$ relaxation times (due to a non-varying $TR$) the calculation of a $PD$ map by this means is not possible. Thus, in order to synthesis images based on the multi-slice $T_2$ Q-maps, the fitted PD from equation (4) was saved as $PD_2$ and will be used when discussing the images synthesis from these multi-slice Q-maps. It may be appreciated that although $PD_2$ should theoretically not differ from the "true" $PD$ maps calculated with a $T_1$ Q-map, due to field inhomogeneities, receiver profiles and the possibility of $T_1$ shine through from a low $TR$ time, alterations can occur.

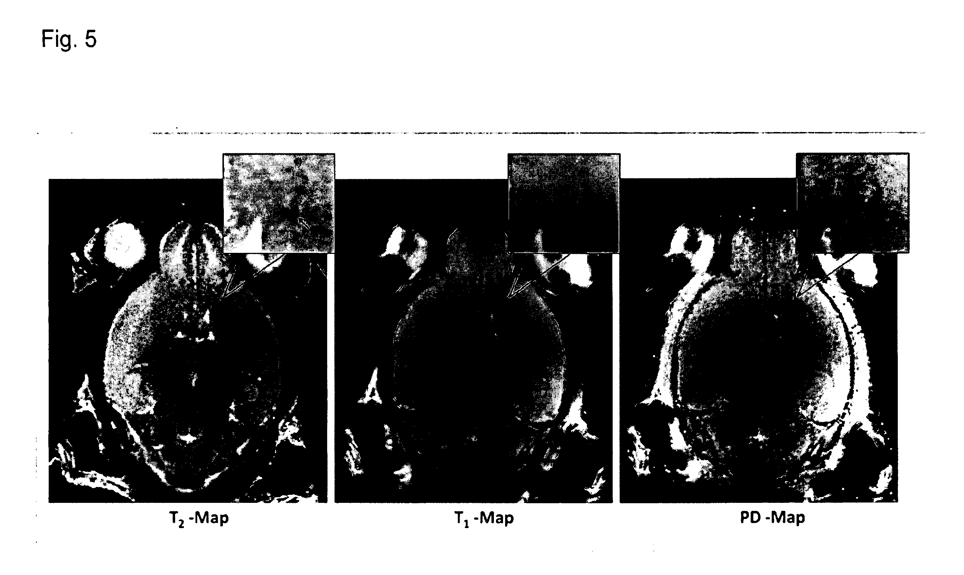

Once the Q-maps have been generated, a visual inspection was made to ensure the stability of the resulting maps. Particular focus was on grouped relaxation times that represent different tissue bodies and respectable contrast between tissue groups (Fig. 5). Upon inspection, hyperintensities around the ears (closet point to the receiving coil) of the animal was seen in the $PD$ maps. These intensities were seen to propagate inwards to the center of the imaging FoV. This intensity artifact is not detectable in either the $T_1$ or $T_2$ Q-map further enforcing the accuracy and stability of the mappings.

In the following, the generation of synthetic parameter-weighted images (which may be considered as images of simulated measurements) based on the Q-maps is explained in more detail. Its ability to enhance contrast between different tissue times, contrast agent and tumour visualisation, nerve imaging and spine imaging particularly in the scope of high field MR animal imaging will be demonstrated.

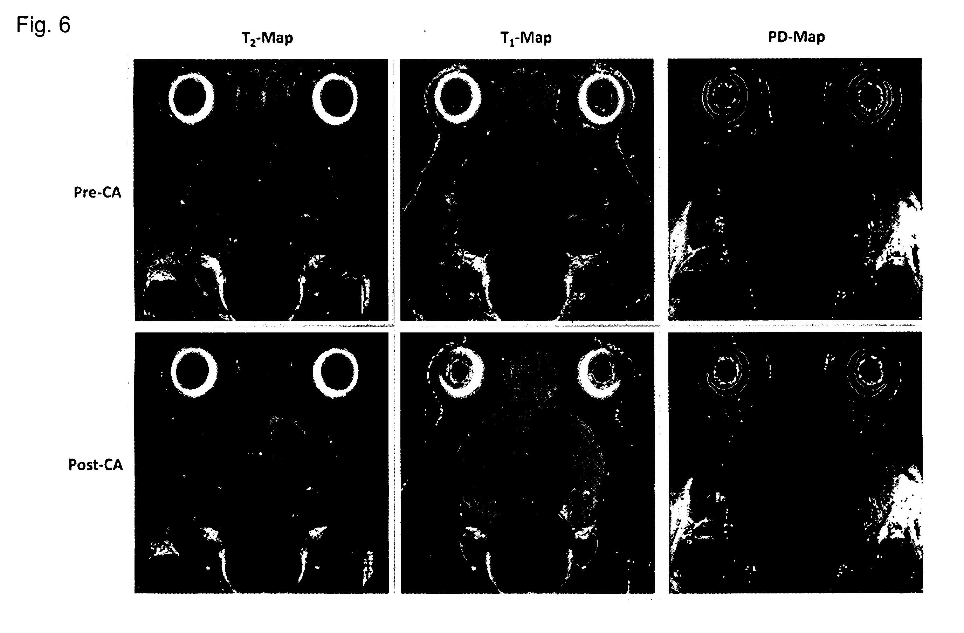

For the development and testing the present invention, mice with an induced glioma tumor were imaged using the above metioned exemplary sequences. To control for CA enhancement and to test the viability of using this technique without a CA, the mice were first imaged before (Pre-CA) and then after (Post-CA) the injection of CA. Q-maps ($T_1$-maps, $T_2$-maps, and proton density maps) were produced both pre and post injection of a contrast agent (CA) for single slice $T_1$ and $T_2$ maps and for multi-slice $T_2$ maps. Results of Q-maps for one mouse are illustrated in Fig. 6.

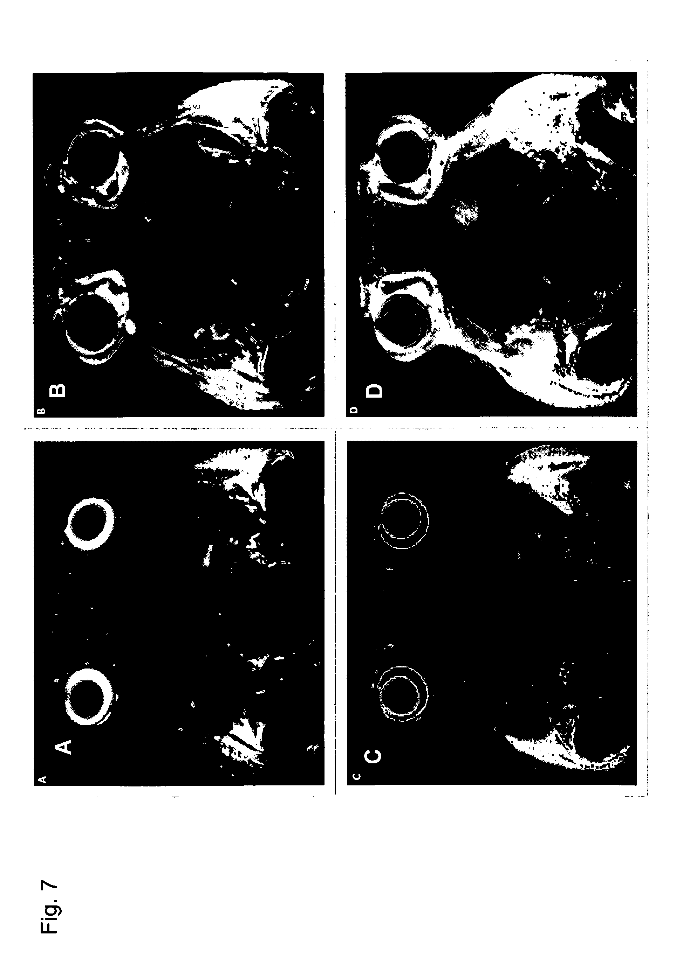

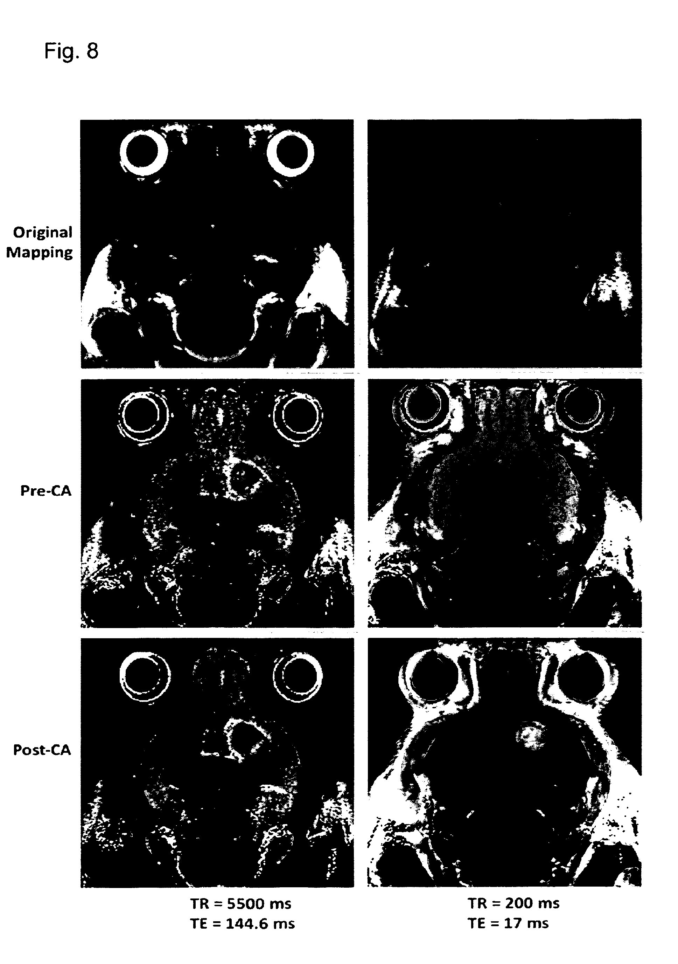

Using these Q-maps, images can be synthesized by applying these Q-maps to equation (1), for example. This equation (1) represents a functional relationship between a magnetic resonance signal that is expected to be measured for a predefined magnetic resonance pulse sequence according to one preferred embodiment of the present invention and a value of the magnetic resonance longitudinal relaxation time $T_1$. A first comparison of standard weighted $T_2$ and $T_1$ imaging sequence (acquired at the MR scanner) and synthesized images with the same $TR$ and $TE$ times show a substantial reduction in noise and an increase in contrast (Fig. 7). The reason for this clarity is due to the fact that the Q-maps consist of values corresponding to relaxation times that are of "pure" nature. Therefore, when using the process of forward calculation (i.e. applying equation (1) based on the Q-maps), a "pure" signal is calculated. This is further validated when comparing the originally acquired mapping images and synthesized images of the same parameters as is presented in Fig. 8.

Although the above described synthesis of MR images may be used even independent of the claimed invention, it will be appreciated from the following description of preferred embodiments of the present invention, that the claimed invention is particularly useful when synthesizing images using the above described mechanism, where a simulation time parameter $T_1^*$ is used instead of the actually acquired $T_1$ time (e.g. from the $T_1$-map).

In other words, the results presented above give a good indication as to the benefits of synthesizing images in the described manner. The benefit from the claimed invention when applying it to the above described process in a preferred embodiment is the further significant reduction in data acquisition time, while still having a very superior image contrast as compared to conventional image processes. In particular, acquiring accurate multi-slice $T_1$ mappings in a short scanning time is technically difficult and is of major interest across the board of MRI to find a suitable method to do this in a clinical setting. The present invention solves this problem.

In particular, a $T_2$-map may be provided in an analogous manner described above. From this $T_2$-map, the present invention proposes to deduce a simulation time parameter $T_1^*$. The rationale behind this is that firstly, $T_1$ relaxation times converge at higher field strength and secondly, the difference between the $T_2$ times of different tissues is not significantly large. Having this in mind one can say that it may be possible to create a simulation of the $T_1$ map by finding a ratio (RR) of measured $T_1$ and $T_2$ times and multiplying it to the $T_2$ time to produce $T_1^*$ according to one preferred embodiment. Using the relaxation times described in Table 2, a ratio between tissue specific regions may be set to be 49.1 $\pm$ 5.4.

Table 2: Relaxation times for various materials (in ms).

| ROI | $T_1$ | $T_2$ | *RR* |
|---|---|---|---|
| ACA | 1611.5 | 36 | 44.8 |
| CC | 1780.6 | 35.4 | 50.3 |
| EC | 1691.6 | 32.2 | 52.5 |
| IC | 1633.1 | 31.7 | 51.5 |
| LGP | 2037.2 | 39.4 | 51.7 |
| CPu | 2029.1 | 39.1 | 51.9 |
| Cortex | 2132.7 | 40.3 | 52.9 |
| Hippocampus | 2158.3 | 43.6 | 49.5 |
| Thalamus | 1861.6 | 36.4 | 51.1 |
| Hypothalamus | 1924.4 | 37.2 | 51.7 |
| RMC | 1904.7 | 36.7 | 51.9 |
| PnO | 1881.9 | 38.2 | 49.3 |
| AP | 1716.8 | 32 | 53.7 |
| PP | 1069.2 | 30.4 | 35.2 |
| LV | 4286.7 | 111.3 | 38.5 |
| **Mean** | | | **49.1** |

(continued)

| ROI | $T_1$ | $T_2$ | *RR* |
|-----|-------|-------|------|
| **STD** | | | **5.4** |

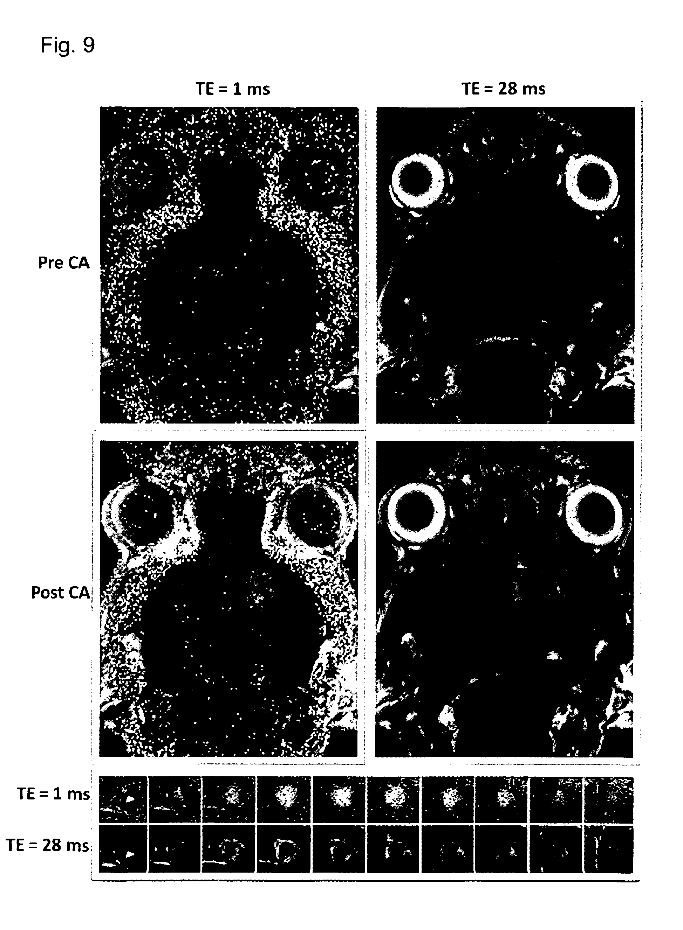

Fig. 9 illustrates the ability to vary the contrast of these acquisitions to depict either the tumour with the edema boarder; as a hyperintense region or suppressing signal coming from CA within the tumour, with the use of multi-slice $T_2$ and the corresponding $PD_2$ Q-maps. In this with an increase in *TE* (*TE* = 28ms) the CA within the tumour mass has been suppressed and its hypointense volume is proportional to the standard $T_1$-weighted images seen in Fig. 7. By decreasing the *TE* value to times outside the bounds of the MR hardware it is possible to enhance the CA to a hyperintense state as is seen when reducing the *TE* time down to 1 ms. Using this method it is now possible to synthesis images based purely on $T_2$ and $PD_2$ Q-maps and gain insight as to a tumours volume (not possible with a single slice acquisition) and its surrounding boundary, as seen in the second group of images in Fig. 9. This, therefore, allows for further studies that would have otherwise been difficult, with the current standard imaging protocols.

From the above results it is clear to see that using a multi-slice $T_2$-mapping one can still synthesis images for tissue specific analysis and investigation. The issue is that it does not allow for the standard hyperintense CA enhance tomor, which most are a custom too, only allows for the varying of one parameter, *TE ,* to modify image contrast, and it does not allow for synthesis of other imaging techniques, such as inversion recover that is based on the knowledge of $T_1$ relaxation times. To these issues a $T_1^*$ map can be introduced to "flip" the intensity of the CA, increase the parameters that can be used to enhance contrast and increase the number of different weighted images that can be produced.

According to a preferred embodiment the $T_1^*$ is a linear function of $T_2$ , e.g.

$$T_1^* = RR \cdot T_2 \qquad (5)$$

with the above explained ratio RR (e.g. RR = 49.1). In another preferred embodiment, the method comprises providing a *PD*-map, which specifies for each of the voxels in the two-dimensional section of a target to be investigated a value *PD* of the proton density (also referred to as $\rho$). Based on this proton density, it is particularly preferred that $T_1^*$ is a linear function of the ratio $\dfrac{T_2}{\rho}$ for each voxel.

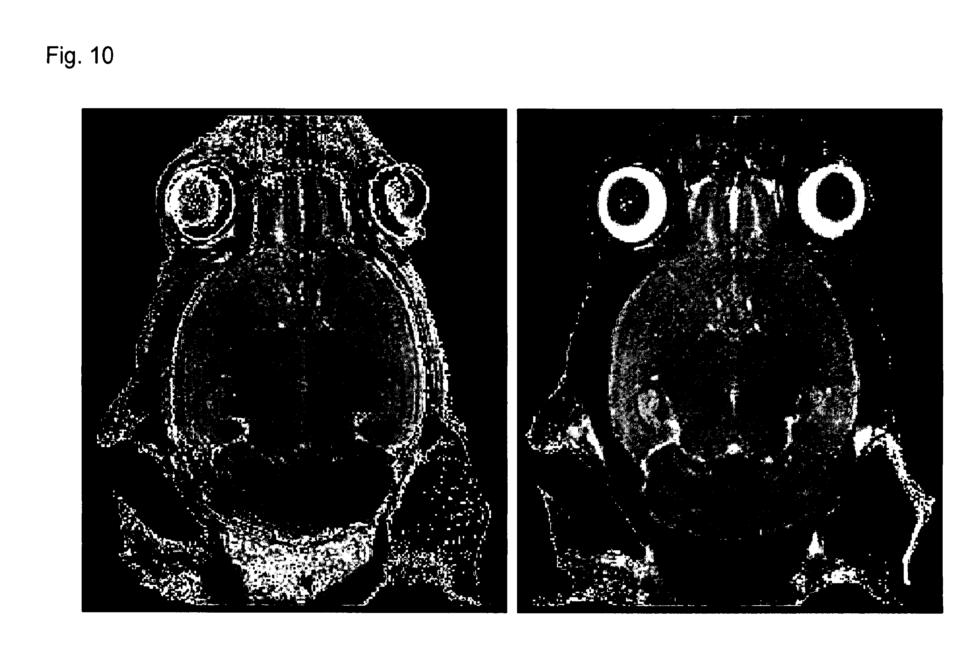

Once the Q-maps were found for all animals the generation of the $T_1^*$ maps could be determined from equation (5), for example, and a comparison to the standard $T_1$ maps could be made. Fig. 10 shows a standard $T_1$ map and the $T_1$ map. From these results it is evident that contrast remains high for different tissue times within the $T_1^*$ map. Furthermore, there is a noticeable difference between the two maps in areas where there is fat and skin due to their large $T_2$ times in comparison to brain tissue.

The advantage of a $T_1^*$ map is not only for the ability to vary *TR ,* which in turn alters contrast, but to enhance the visualization of a CA. Fig. 11 presents an animal with an induced tumor. When comparing the $T_1^*$ map to the calculated single slice $T_1$ map the area of CA can be seen to have the same trend. That is, the effect of CA induces hypointensity in $T_1$ maps. What is also noted is that the diameter of the induce contrast hypointensity in the $T_1^*$ map does not match that of the standard $T_1$ map. The reason for this is due to the signal coming from the boundary of the tumor. In this case, the boundary is an edema formation which when mapping for $T_1$ (signal vs. *TR*) there is a limited difference in the fitted curve used to determine the $T_1$ times (Fig. 11). However, for $T_2$ exponential decay the difference becomes more apparent and the tumor has significantly different $T_2$ relaxation times in comparison to the bounding edema, remembering that this is the measure of the CA within the tumor.

The importance of having a hypointense region for an area of CA in a $T_1^*$ map can be seen by the signal equation where signal is proportional to (1-exp(-$TR/T_1$)). In this case the hypointense region in a $T_1$ map will become hyperintense in spin echo sequences and thus a synthesised image based on this equation will aid in the segmentation of the tumor.

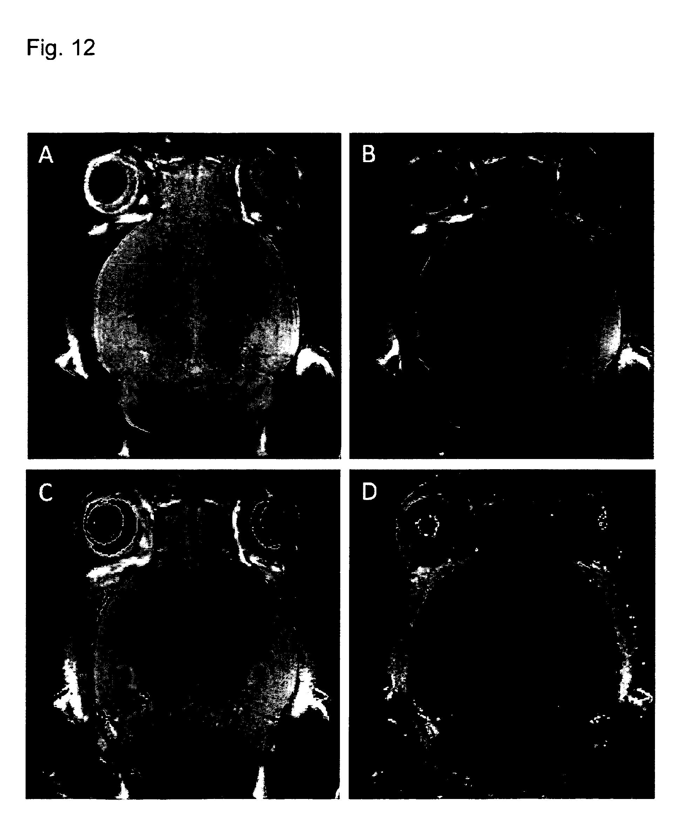

Thus, image synthesis provides the ability to weight images with a desired contrast by varying *TR* and/or *TE.* The issue is, however, that without a $T_1$ map, contrast can only be tailored by varying *TE* as *TR* effects $T_1$ weighting. With the use of $T_1^*$ map the present invention preferably also allows to vary *TR* and thus obtain contrast as if an actual calculated $T_1$ map was used. Fig. 12 illustrates 2 different weighted images with the standard $T_1$ map and with the $T_1^*$ map. The $T_2$ weighted synthesized image with the $T_1^*$ map is presented with high contrast comparable to the image with a standard $T_1$ map. $T_1$ synthesised weighting, although darker, shows high contrast particularly in the basal ganglia region and olfactory bulb.

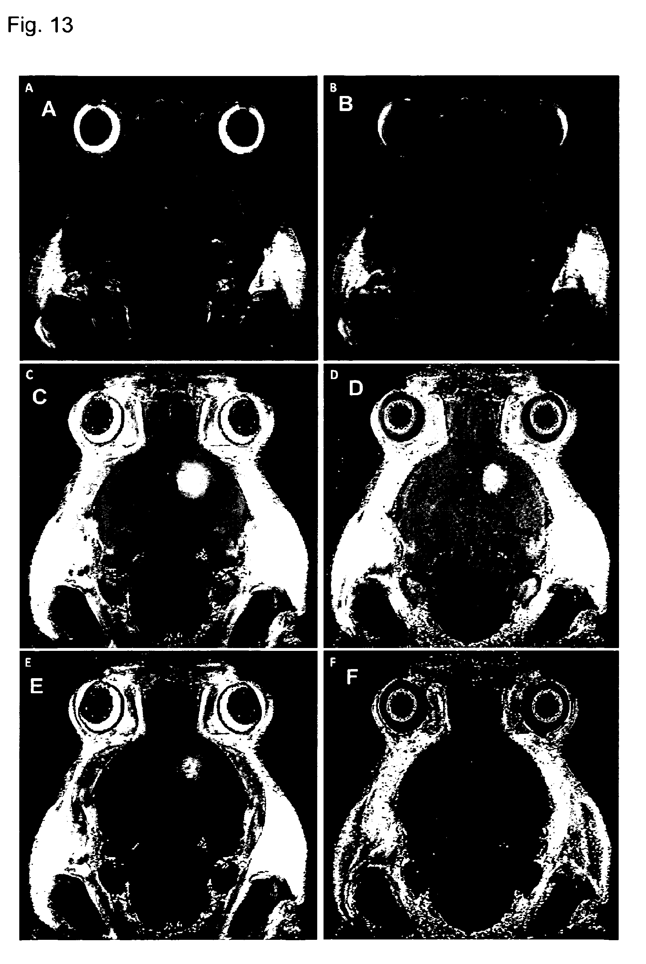

Along with weighting an image either by $T_1$ or $T_2$, another advantage of the $T_1^*$ becomes apparent when investigating region of CA. Fig. 13 illistrates the described synthetic parameter weighted imaging technique with the use of a $T_1^*$ map on contrast enhanced tumors. Not only is it now possible to see the contrast enhanced tumor using a simulated map but it is possible to use this method as a multi-slice method allowing for volumetric analysis of the tumor. Furthermore, segmentation can be done by hand on pixels and regions that are hyperintense but with the use of an inversion recovery (IR) equation, one is able to suppress the background tissue with an inversion representing time *(TI)* leaving a hyperintense segmented tumor.

To ensure the volume of the enhanced tumors of the synthesised images matches those that are seen in standard $T_1$-weighted images, semi-automated segmentation was undertaken on both standard multi-slice weighted $T_1$ images and $T_1$ weighted synthesized images with the $T_1^*$ based on the multi-slice $T_2$ maps for all mice with implated tumors. The results showed close matching volumes with a mean difference of only $\pm$ 0.07 mm$^3$.

A means for simulating a $T_1$ based on $T_2$ and possibly also based on proton density maps has been described with reference to preferred embodiments. Even though $T_1^*$ maps are not identical to $T_1$ maps from their physical nature, they can be efficiently used as weighting map to create weighted synthesized images. The rationale behind the ability to simulate theses maps is explained by the convergence of the $T_1$ relaxation times in high magnetic field strengths. It has been shown that by integrating such a simulated map with a parametric image synthesis technique one can weight an image with a $T_1$ weighting by varying the *TR* time as opposed to being only able to vary the *TE* time for multi-slice $T_2$ maps. It should also be stated that by implementing such a $T_1$ map the value that has been referred to as *TR* (pulse repetition time) is not necessarily comparable to the actual *TR* on a MR machine but be another weighting parameter. Furthermore, with this included $T_1$ simulated map it has been shown that CA enhanced tissues can be seen hyperintense matching closely to synthesised images using standard $T_1$ maps. Moreover, it was revealed that the hyperintense region matched closer to standard $T_1$ weighted acquisition and provided significantly matching volumetric results. It also was illustrated that the standard $T_1$ maps had issues when closely bounded edema gave a closely relating $T_1$ increase yielding a diameter of a contrast enhanced tumor larger than that seen in a $T_1$-weighted images. That is, the hypointense region seen within a standard $T_1$ map includes the edema filled region.

**Claims**

1.  Magnetic resonance imaging method comprising:

    - providing a $T_2$ -map, which specifies for a plurality of voxels in a two-dimensional section of a target to be investigated a value $T_2$ of the magnetic resonance transverse relaxation time;

- deducing for each voxel a simulation time parameter value $T_1^*$ from the respective value $T_2$;

- providing a functional relationship $S = S(T_1)$ between a magnetic resonance signal $S$ that is expected to be measured for a predefined magnetic resonance pulse sequence and a value $T_1$ of the magnetic resonance longitudinal relaxation time at each voxel;

- calculating an imaging signal $S^* = S(T_1^*)$; and

- outputting a two-dimensional image of the imaging signal $S^* = S(T_1^*)$.

2. Method of claim 1, wherein the $T_2$ -map is provided for a magnetic field of at least about 1.5 T, preferably at least about 5 T, more preferably at least about 7.5 T even more preferably at least about 9 T.

3. Method according to claim 1 or 2, wherein $T_1^*$ is a linear function of $T_2$ .

4. Method according to any one of claims 1 to 3, comprising providing a *PD*-map, which specifies for each of the voxels a value $\rho$ of the proton density, wherein $T_1^*$

is a linear function of the ratio $\dfrac{T_2}{\rho}$ .

5. Method according to any one of the claims 1 to 4, further comprising determining a pulse repetition time TR and a spin echo time *TE* , wherein the functional relationship between the magnetic response signal and the longitudinal relaxation time is provided as $S(T_1) = b\left(1 - \exp\left(-\dfrac{TR}{T_1}\right)\right)\exp\left(-\dfrac{TE}{T_2}\right)$ with a predefined factor *b*.

6. Method according to any one of the claims 1 to 4, further comprising determining an inversion time *TI,* a pulse repetition time *TR,* and a spin echo time TE , wherein the functional relationship between the magnetic response signal and the longitudinal relaxation time is provided as

$$S(T_1) = b\left(1 - 2\exp\left(-\dfrac{TI}{T_1}\right) + \exp\left(-\dfrac{TR}{T_1}\right)\right)\exp\left(-\dfrac{TE}{T_2}\right)$$ with a predefined factor *b*.

7. Method according to claim 5 or 6, comprising providing a *PD*-map, which specifies for each of the voxels a value *p* of the proton density, wherein the factor *b* is proportional to the proton density $\rho$.

8. Method according to any one of claims 5 to 7, comprising receiving a user input that specifies the pulse repetition time *TR.*

9. Method according to any one of claims 5 to 8, comprising receiving a user input that specifies the spin echo time *TE.*

10. Method according to any one of the preceding claims, wherein providing the $T_2$-map comprises:

- acquiring a plurality of spin echo signals $S$ of a spin echo pulse sequence at different spin echo times *TE ;* and

- identifying values of the parameters *a* , $S_0$ , and $T_2$ such that the curve $S(TE) = a + S_0 \exp\left(-\dfrac{TE}{T_2}\right)$ fits the acquired value pairs *(TE,S)* best.

**11.** Magnetic resonance imaging device, comprising:

- a data acquisition module for providing a $T_2$-map, which specifies for a plurality of voxels in a two-dimensional section of a target to be investigated a value $T_2$ of the magnetic resonance transverse relaxation time;

- a time simulation module for deducing for each voxel a simulation time parameter value $T_1^*$ from the respective value $T_2$;
- a model repository for providing a functional relationship $S = S(T_1)$ between a magnetic resonance signal S that is expected to be measured for a predefined magnetic resonance pulse sequence and a value $T_1$ of the magnetic resonance longitudinal relaxation time at each voxel;

- a signal simulation module for calculating an imaging signal $S^* = S\!\left(T_1^*\right)$; and

- an imaging module for outputting a two-dimensional image of the imaging signal $S^* = S\!\left(T_1^*\right)$.

**12.** Device according to claim 11, wherein the data acquisition module comprises a magnetic resonance imaging scanner.

**13.** Device according to claim 11 or 12, wherein the functional relationship between the magnetic response signal and the longitudinal relaxation time is provided as $S(T_1) = b\left(1 - \exp\left(-\dfrac{TR}{T_1}\right)\right)\exp\left(-\dfrac{TE}{T_2}\right)$ with a predefined factor $b$, a pulse repetition time $TR$, and a spin echo time $TE$, wherein the device further comprises a user interface for receiving a user input that specifies the pulse repetition time $TR$.

**14.** Computer-program product including computer-readable code which, when loaded in a computer system causes the computer system to perform operations according to a method of any one of the claims 1 to 10.

Fig. 1

Fig. 2

Fig. 3

TR=      5500 ms          3000 ms          1500 ms

TR=      800 ms          400 ms          200 ms

EP 2 757 386 A1

Fig. 4

TE=

16 ms

40 ms

65 ms

TE=

89 ms

114 ms

138 ms

EP 2 757 386 A1

Fig. 5

T$_2$ -Map          T$_1$ -Map          PD -Map

EP 2 757 386 A1

Fig. 6

PD-Map    T₁-Map    T₂-Map

Pre-CA    Post-CA

Fig. 7

Fig. 8

| | TR = 5500 ms<br>TE = 144.6 ms | TR = 200 ms<br>TE = 17 ms |

Fig. 9

TE = 1 ms                    TE = 28 ms

Pre CA

Post CA

TE = 1 ms

TE = 28 ms

Fig. 10

Fig. 11

Fig. 12

Fig. 13

Europäisches
Patentamt

European
Patent Office

Office européen
des brevets

**EUROPEAN SEARCH REPORT**

Application Number

EP 13 00 0239

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PETERSSON J S ET AL: "MRI simulation using the k-space formalism", MAGNETIC RESONANCE IMAGING, ELSEVIER SCIENCE, TARRYTOWN, NY, US, vol. 11, no. 4, 1 January 1993 (1993-01-01), pages 557-568, XP026297333, ISSN: 0730-725X, DOI: 10.1016/0730-725X(93)90475-S [retrieved on 1993-01-01] * page 559 - page 564; figures 1-5, 8-10 * ----- | 1-14 | INV. G01R33/50 G01R33/56 |
| X | REMI K-S KWAN ET AL: "An extensible MRI simulator for post-processing evaluation", 22 September 1996 (1996-09-22), VISUALIZATION IN BIOMEDICAL COMPUTING : 4TH INTERNATIONAL CONFERENCE, VBC' 96, HAMBURG, GERMANY, SEPTEMBER 22-25, 1996, SPRINGER, DE, PAGE(S) 135 - 140, XP019193753, ISBN: 978-3-540-61649-8 * page 136, paragraph 2 - page 137, paragraph 4; figures 1, 3-5 * ----- | 1-14 | |
| X | REMI K-S KWAN ET AL: "MRI Simulation-Based Evaluation of Image-Processing and Classification Methods", IEEE TRANSACTIONS ON MEDICAL IMAGING, IEEE SERVICE CENTER, PISCATAWAY, NJ, US, vol. 18, no. 11, 1 November 1999 (1999-11-01), XP011035919, ISSN: 0278-0062 * the whole document * ----- -/-- | 1-14 | TECHNICAL FIELDS SEARCHED (IPC) G01R |

The present search report has been drawn up for all claims

| Place of search | Date of completion of the search | Examiner |
|---|---|---|
| Munich | 22 May 2013 | Raguin, Guy |

EPO FORM 1503 03.82 (P04C01)

**Europäisches Patentamt**
**European Patent Office**
**Office européen des brevets**

# EUROPEAN SEARCH REPORT

Application Number

EP 13 00 0239

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BENOIT-CATTIN H ET AL: "The SIMRI project: a versatile and interactive MRI simulator", JOURNAL OF MAGNETIC RESONANCE, ACADEMIC PRESS, ORLANDO, FL, US, vol. 173, no. 1, 1 March 2005 (2005-03-01) , pages 97-115, XP004739000, ISSN: 1090-7807, DOI: 10.1016/J.JMR.2004.09.027 * page 98, column 2, paragraph 4 - page 101; figures 1, 6 * | 1-14 | |
| T | OROS-PEUSQUENS A M ET AL: "Magnetic field dependence of the distribution of NMR relaxation times in the living human brain", MAGNETIC RESONANCE MATERIALS IN PHYSICS, BIOLOGY AND MEDICINE, CHAPMAN AND HALL, LONDON, GB, vol. 21, no. 1-2, 13 March 2008 (2008-03-13), pages 131-147, XP019596835, ISSN: 1352-8661 * page 133; table 1 * | 1-14 | |
| A | JENSEN J H ET AL: "MR IMAGING OF MICROVASCULATURE", MAGNETIC RESONANCE IN MEDICINE, ACADEMIC PRESS, DULUTH, MN, US, vol. 44, no. 2, 1 August 2000 (2000-08-01) , pages 224-230, XP000947388, ISSN: 0740-3194, DOI: 10.1002/1522-2594(200008)44:2<224::AID-MRM9>3.0.CO;2-M * the whole document * | 1-14 | TECHNICAL FIELDS SEARCHED (IPC) |

-/--

The present search report has been drawn up for all claims

| Place of search | Date of completion of the search | Examiner |
|---|---|---|
| Munich | 22 May 2013 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..............................................................................

& : member of the same patent family, corresponding document

EPO FORM 1503 03.82 (P04C01)

## EUROPEAN SEARCH REPORT

Europäisches
Patentamt
European
Patent Office
Office européen
des brevets

Application Number

EP 13 00 0239

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HENRIKSEN O ET AL: "V. In vivo field dependence of proton relaxation times in human brain, liver and skeletal muscle: A multicenter study", MAGNETIC RESONANCE IMAGING, ELSEVIER SCIENCE, TARRYTOWN, NY, US, vol. 11, no. 6, 1 January 1993 (1993-01-01), pages 851-856, XP026307638, ISSN: 0730-725X, DOI: 10.1016/0730-725X(93)90202-0 [retrieved on 1993-01-01] * the whole document * | 1-14 | |
| A | SHALOM MICHAELI ET AL: "ProtonT2 relaxation study of water, N-acetylaspartate, and creatine in human brain using Hahn and Carr-Purcell spin echoes at 4T and 7T", MAGNETIC RESONANCE IN MEDICINE, vol. 47, no. 4, 28 March 2002 (2002-03-28) , pages 629-633, XP055060827, ISSN: 0740-3194, DOI: 10.1002/mrm.10135 * the whole document * | 1-14 | |
| A | WILLIAM D. ROONEY ET AL: "Magnetic field and tissue dependencies of human brain longitudinal 1H2O relaxation in vivo", MAGNETIC RESONANCE IN MEDICINE, vol. 57, no. 2, 26 January 2007 (2007-01-26), pages 308-318, XP055060830, ISSN: 0740-3194, DOI: 10.1002/mrm.21122 * the whole document * | 1-14 | TECHNICAL FIELDS SEARCHED (IPC) |

-/--

The present search report has been drawn up for all claims

| Place of search | Date of completion of the search | Examiner |
|---|---|---|
| Munich | 22 May 2013 | Raguin, Guy |

EPO FORM 1503 03.82 (P04C01)

Europäisches
Patentamt

European
Patent Office

Office européen
des brevets

# EUROPEAN SEARCH REPORT

Application Number

EP 13 00 0239

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KEVIN J CHANG ET AL: "Applications of quantitative T1, T2, and proton density to diagnosis", APPLIED RADIOLOGY, vol. 34, no. 1, 1 January 2005 (2005-01-01), pages 34-42, XP055060880, * the whole document * | 1-14 | |

-----

TECHNICAL FIELDS
SEARCHED     (IPC)

The present search report has been drawn up for all claims

| Place of search | Date of completion of the search | Examiner |
|---|---|---|
| Munich | 22 May 2013 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)